# EUROPEAN PATENT APPLICATION

(11) **EP 1 178 084 A1**
(43) Date of publication of application: **06.02.2002**
(21) Application number: 00202725.8
(22) Date of filing: 31.07.2000
(51) Int. Cl.: C09B 57/10, C07F 15/00, H01G 9/20

(54) **Processes for the preparation of carboxylate and phosphonate ruthenium polypyridine dyes and intermediates**

(71) Applicant: Neomat S.A., 1219 Luxembourg (LU)
(72) Inventor: Alebbi, Monica, 44011 Argenta (Ferrara) (IT); Costa, Emiliana, 48021 Lavezzola (IT); Bignozzi, Carlo Alberto, 44100 Ferrara (IT)
(74) Representative: Luppi, Luigi

(57) **Abstract**

The present invention relates to processes for the preparation of carboxylate and phosphonate Ruthenium Polypyridine Dyes and for the preparation of reaction intermediates used in such process.

## Description

The present invention relates to a process according to the preamble of claims 1, 6 and 11 and to the use of the compounds prepared in these processes.

The present invention refers to a process for the preparation of mononuclear compounds of general formula (I) - (V), where the term mononuclear is used to identify metal complexes containing only one metal center.

Ru(dcbH₂)₂(X)₂ (I)

Ru(dcbH₂)₂(Y) (II)

Ru[trpy(COOH)₃](X)₃ (III)

Ru[(PO₃H₂)ₙ(CH₂)ₘbpy]₂(X)₂ (IV)

Ru[(PO₃H₂)ₙ(CH₂)ₘbpy]₂(Y) (V)

wherein:
dcbH₂ is 4,4'-dicarboxy-2,2'-bipyridine or 5,5'-dicarboxy-2,2'-bipyridine;
trpy(COOH)₃ is 4,4',4''-tricarboxy-2,2',6',2''-terpyridine
[(PO₃H₂)ₙ(CH₂)ₘbpy]₂ are bipyridine ligands which may contain one (when one n = 0 and the other n = 1) or two (when the two n = 1) phosphonic acid groups in 4,4' or 5,5' position, and such groups can be directly bound to the bipyridine ligand (m = 0) or attached to the bipyridine ligand through a methylene spacer (m = 1).
X is a mono-dentate ligand and Y is a bi-dentate ligand, where the term monodentate indicates that the ligand possesses only one binding site while the term bidentate indicates that the ligand possesses two binding sites through which the ligand can be bound to the metal center. X and Y are defined hereafter at page 5.

The charge of the complexes schematized by general formulae I-V, which is not specified, is given by the algebraic sum of the oxidation state of the Ru center, in all cases equal to 2+, with the charge of the coordinated X or Y ligands, which can be neutral or negatively charged.

Such compounds are useful for example as inorganic dyes for the sensibilisation of wide band-gap semiconductors of type n, (where n stands for negative) for example titanium dioxide, tin dioxide, zinc oxide. In another possible application these types of dyes can be adsorbed on the surface of wide band gap semiconductors or of amorphous silica to produce a photosensitive material which undergoes a color change following irradiation in the Ultraviolet-Visible region, defined by the wavelength range from 200 to 800 nm.

Such dyes are used, for example, as molecular sensitizers in photoelectrochemical regenerating cells based on nanocrystalline electrodes of titanium dioxide (where the term nanocrystalline indicates that the size of the semiconductor particles are in the nanometer range) (M.K. Nazeeruddin et al. *J.Am.Chem.Soc*. 1993, *115*, 6382; M.K Nazeeruddin et al. Chem. Commun., 1997, 1705; C. A. Bignozzi et al. Chem. Soc. Rev. **2000**, *29,* 87.).

In the literature [see: Nazeeruddin M.Z. et al. *J.Am.Chem.Soc*. 1993, *115*, 6382; Heimer T.A. et al. *J.Phys.Chem*. 1993, *97*, 11987; Argazzi R. et al. *Inorg. Chem*. 1994, *33*, 5741; M.K Nazeeruddin et al. Chem. Commun., 1997, 1705] processes for the preparation of compounds of formula (I) and (II) hereabove are described comprising, as reaction intermediate, the complex Ru(dcbH₂)₂(Cl)₂, or its deprotonated form Ru(dcb)₂(Cl)₂⁴⁻, obtained by neutralisation of Ru(dcbH₂)₂(Cl)₂.

The above said complex is obtained by reaction of RuCl₃ hydrate, commercially available, with dcbH₂, in organic solvents, as for example DMF, at boiling point. Although the reaction itself runs with a relatively good yield (70%), a prolonged reaction time, of the order of 8 hours, is required to reach such yield.

Complexes of type III are produced through the reaction intermediate Ru[trpy(COOCH₃)₃](X)₃ , which is obtained by reacting the 4,4',4''-trimetoxycarbonyl-2,2',6',2''-terpyridine ligand with RuCl₃ hydrate, commercially available. This reaction requires the esterification of 4,4',4''-tricarboxy-2,2',6',2''-terpyridine ligand, which is carried out by refluxing the trpy(COOH)₃ ligand in methanol/H₂SO₄ for ca. 70 hours. The subsequent reaction between trpy(COOCH₃)₃ and RuCl₃ hydrate to form Ru[trpy(COOCH₃)₃](Cl)₃ requires two hours at reflux in methanol. As reported by M.K Nazeeruddin et al. Chem. Commun., 1997, 1705, the final conversion of the Ru[trpy(COOCH₃)₃](Cl)₃ complex into useful species such as thiocyanate complexes of the type [Ru[trpy(COOH)₃](NCS)₃]⁻, requires the reaction of Ru[trpy(COOCH₃)₃](Cl)₃ with an excess of NCS⁻ at reflux in dimethylformamide/water for 3.5 hours, and the subsequent hydrolysis of the ester groups at reflux for 15 hours in the presence of triethylamine.

Complexes of type IV and V are of particular interest since they may provide a stronger bond with the TiO₂ semiconductor due to the presence of the phosphonic acid groups (Trummell S.; Wimbish J.; Meyer T.J.; Odobel F. *J. Am. Chem. Soc.* 1998, *120,* 13248). These species can also be prepared through an intermediate dichloro species of general formula:
Ru[(PO₃H₂)ₙ(CH₂)ₘbpy]₂(Cl)₂ following the general procedure reported for the analogous carboxylate species. The formation yield of the dichloro species is however very low, lower than 10%, limiting therefore the production of dyes of general formula (IV) and (V).

The present invention relates to a process according to the characterizing part of claims 1, 6 and 11 and to the use of the compounds prepared in these processes.

The object of the present invention are two synthetic processes hereafter indicated by method A and B for the preparation of intermediate species which are the precursors of the mononuclear compounds of general formula (I)-(III) and (IV)-(V), respectively.

### Method A:

The method A can be successfully applied to the synthesis of the Ru(dcbH₂)₂(Cl)₂ complex, which represents the intermediate species in the process of preparation of dye molecules of general formulae:

Ru(dcbH₂)₂(X)₂ (I)

Ru(dcbH₂)₂(Y) (II)

wherein:
dcbH₂ is 4,4'-dicarboxy-2,2'-bipyridine or a 5,5'-dicarboxy-2,2'-bipyridine
X is a mono-dentate ligand, such as for example: CN⁻, NCS⁻, py, NC-(CH₂)₂-CN, NC-(CH₂)₃-CN, NC-(CH₂)₄-CN, halide, CO, NO, pyridine, 4-cyanopyridine, dicyanobenzene, H₂O, NH₃, or NO₂⁻.
Y is a bi-dentate ligand of the type: 2,2'-bipyridyl unsubstituted or substituted by one or two -COOH, -B(OH)₂, -PO₃H₂, or -R-PO₃H₂ groups (where R is a saturated or aromatic spacer group, e.g., methylene or phenyl); 1,10-phenanthroline unsubstituted or substituted by one or two-COOH, -B(OH)₂, -PO₃H₂, or -R-PO₃H₂ groups (where R is as defined above); or 2,2'-biquinoline unsubstituted or substituted by one or two -COOH, -B(OH)₂, -PO₃H₂, or -R-PO₃H₂ groups (where R is as defined above).

This method involves the use of a microwave reactor which can be obtained by modifying a commercially available microwave oven in which a reflux condenser for the glass reactor is set through a hole on the top of the oven. The relevant advantage in the use of such preparation method is the extremely short reaction time, of the order of a few minutes, which is required to reach high yield of reaction, exceeding 80%.

Subsequent substitution reactions of the chloride ligands to form complexes of type (I) and (II) can also be performed in the same microwave reactor.

This method has been found in addition extremely useful for the fast preparation of terpyridine complexes of the type:

Ru[trpy(COOH)₃](X)₃ (III)

where trpy(COOH)₃ is 4,4',4''- tricarboxy-2,2',6',2''-terpyridine, and X is a mono-dentate ligand, where the term monodentate indicates that the ligand possesses only one binding site. The method allows in fact to produce in a few minutes a useful intermediate species of the type Ru[trpy(COOH)₃](Cl)₃, and to carry out also substitution reaction in a time scale of minutes of the coordinated chloride with anionic species of the type NCS-, CN-, to form molecular sensitizers useful for the conversion of solar energy into electricity in solar cells based on sensitized nanocrystalline TiO₂. Details on this type of solar cells are described in the litterature (see for example M.K. Nazeeruddin et al. *J.Am.Chem.Soc*. 1993, *115*, 6382; C. A. Bignozzi et al. Chem. Soc. Rev. **2000**, *29,* 87).

### Method B:

The method B can be succesfully applied to the high yield preparation of the oxalate complex Ru[(PO₃R₂)ₙ(CH₂)ₘbpy]₂(C₂O₄) , (R = methyl or ethyl or, more in general, an alkyl group) which represents a useful intermediate for the synthesis of mononuclear complexes of type (IV) and (V)

Ru[(PO₃H₂)ₙ(CH₂)ₘbpy]₂(X)₂ (IV)

Ru[(PO₃H₂)ₙ(CH₂)ₘbpy]₂(Y) (V)

wherein:
[(PO₃H₂)ₙ(CH₂)ₘbpy]₂ are bipyridine ligands which may contain one (when one n = 0 and the other n = 1) or two (when the two n = 1) phosphonic acid groups in 4,4' or 5,5' position, and such groups can be directly bound to the bipyridine ligand (m = 0) or attached to the bipyridine ligand through a methylene spacer (m = 1).
X is a mono-dentate ligand of the type: CN⁻, NCS⁻, py, NC-(CH₂)₂-CN, NC-(CH₂)₃-CN, NC-(CH₂)₄-CN, halide, CO, NO, pyridine, 4-cyanopyridine, dicyanobenzene, H₂O, NH₃ or NO₂⁻.
Y is a bi-dentate ligand of the type: 2,2'-bipyridyl unsubstituted or substituted by one or two -COOH, -B(OH)₂, -PO₃H₂, or -R-PO₃H₂ groups (where R is a saturated or aromatic spacer group, e.g., methylene or phenyl); 1,10-phenanthroline unsubstituted or substituted by one or two-COOH, -B(OH)₂, -PO₃H₂, or -R-PO₃H₂ groups (where R is as defined above); or 2,2'-biquinoline unsubstituted or substituted by one or two -COOH, -B(OH)₂, -PO₃H₂, or -R-PO₃H₂ groups (where R is as defined above).

### Method A

The invention will be better understood in the light of the following detailed procedures:

### Preparation of Ru(dcbH₂)₂Cl₂.

A 150- 500 mg amount, preferably 250 mg of commercially available ruthenium trichloride and a 250-800 mg, preferably 420 mg of the dcbH₂ ligand are suspended in 30- 100 ml, preferably 50 ml of dimethylformamide in a 50-200 ml, preferably 100 ml glass reactor. The mixture is irradiated with microwaves for 8-20 min, preferably 12 min by using a power in the range 250- 450 W. The solvent is rotary evaporated and the solid stirred in 30- 80 ml, preferably 40 ml of HCl 2 M for 4 hours in the dark. The solid is then filtered and dried in the temperature range 60-90 °C, preferably 80 °C under vacuum giving a yield from 80 to 85 %, preferably of 82 % of pure Ru(dcbH₂)₂Cl₂. This yield corresponds to 470 mg of pure product when 250 mg of RuCl₃ are reacted. Elemental analysis Ru(dcbH₂)₂Cl₂ x 3H₂O, (C₂₄H₁₈N₄O₁₀Ru x 3H₂O). Calculated: C, 42.55; H, 2.68; N, 8.27. Found: C, 42.38; H, 2.70; N, 8.02.

It should be noted that with respect to known methods of preparation of the intermediate dichloro species, the procedure described in this invention allows to reduce of 40 times the reaction time allowing for the obtainment of a higher yield of product formation. The beneficial economic implication can be straightforwardly understood.

### Preparation of Ru(dcbH₂)₂(NCS)₂.

A 100- 400 mg amount, preferably 200 mg of Ru(dcbH₂)₂Cl₂ and 1.4- 5.5 gr, preferably 2.73 gr of TBANCS (where TBA is the tetrabuthylammonium cation) are suspended in 6-24 ml, preferably 12 ml of a solution containing 5-20 ml, preferably 10 ml of dimethylformamide and 1-4 ml, preferably 2 ml of water in a 25-100 ml, preferably a 50 ml glass reactor. The mixture is irradiated with microwaves for 20-50 min, preferably 30 min with a power in the range 200-450W. The solvent is then evaporated and the solid dissolved at pH 7 in water. The solution filtered and the Ru(dcbH₂)₂(NCS)₂ complex precipitated at pH 3 by addition of HClO₄. The procedure of dissolution of the product at pH 7 and precipitation at pH 3 is repeated two additional times to get rid of the TBANCS salt in excess. The product is finally washed with water and dried. Repeated preparations gave a product formation yield in the range 80-85 %. Elemental analysis of Ru(dcbH₂)₂(NCS)₂x2H₂O, corresponding to (RuC₂₆H₁₆N₆S₂O₈ x 2 H₂O), Calculated: C, 42.10; H, 2.72; N, 11.34. Found: C, 41.32; H, 2.78; N, 11.30.

Reactions carried out under microwave irradiation of the Ru(dcbH₂)₂(Cl)₂ species with monodentate ligands of the type: CN⁻, py, or polydentate ligands of the type: dithiocarbammates, β-diketonates, 2,2'-bipyridine, 1-10-phenantroline, biquinoline and the ester derivatives of 2,2'-bipyridine, 1-10-phenantroline, biquinoline, gave complexes of type I and II with variable yields of reaction in the range 60-85% with reaction times in the range 10-50 minutes.

The method can also be applied to the preparation of analogous complexes of Os of general formula Os(dcbH₂)₂(X)₂; Os(dcbH₂)₂(Y).

### Preparation of Ru[trpy(COOH)₃](Cl)₃

A 50- 500 mg amount, preferably 250 mg of commercially available hydrated ruthenium trichloride and a 70-700 mg amount, preferably 350 mg of the trpy(COOH)₃ ligand are suspended in 7-70 ml, preferably 35 ml of dimethylformamide in a 50- 200 ml, preferably 100 ml glass reactor. The mixture is irradiated with a microwaves for 5-15 min, preferably 8 min by using a power in the range 250-700 W, preferably 375 W. The solvent is rotary evaporated and the solid redissolved in a small volume of methanol and reprecipitated with diethylether, giving 440 mg of the trichloro species, corresponding to a yield of 80%.

Elemental analysis of Ru[trpy(COOH)₃](Cl)₃, corresponding to (C₁₈H₁₁N₃O₆RuCl₃), Calculated: C, 37.75; H, 1.94; N, 7.34. Found: C, 36.88; H, 2.07; N, 7.12.

### Preparation of (TBA)₃[Ru[trpy(COOH)(COO⁻)₂](NCS)₃

A 100- 500 mg amount, preferably 300 mg of Ru[trpy(COOH)₃](Cl)₃ and 1.5- 7.9 gr amount, preferably 4.7 gr of TBANCS (where TBA is the tetrabuthylammonium cation) are suspended in 15-75 ml, preferably 45 ml of dimethylformamide, in a 50-250 ml, preferably a 100 ml glass reactor. The mixture is irradiated with microwaves for 5-20 min, preferably 10 min with a power in the range 200-450W, preferably 375 W. The solvent is then evaporated and the solid dissolved at pH 9 in water by the addition of 0.1 M tetrabutylammonium hydroxide solution. The solution is filtered and the (TBA)₃[Ru[trpy(COOH) (COO⁻)₂] (NCS)₃ complex precipitated in the pH range 4.8-5.0, preferably 4.9 by addition of acid, keeping the solution in an ice bath. The solution is then filtered giving a solid product formation yield of 75-80 %. Elemental analysis of (TBA)₃[Ru[trpy(COOH)(COO⁻)₂](NCS)₃, corresponding to (C₆₉H₁₁₇N₉O₆S₃Ru), Calculated: C, 60.67; H, 8.63; N, 9.23. Found: C, 61.44; H, 9.38; N, 8.30.
¹H NMR (300 MHz, CD₃OD) ppm: 1.00 (36H, t), 1.38 (24H, m), 1.65 (24H, m), 3.20 (24H, m), 8.18 (2H, d, J6 Hz), 8.96 (4H, s), 9.12 (2H, d, J6 Hz).
Absorption maximum in ethanol: 610 nm;
Emission maximum in ethanol: 855 nm

It should be noted that with respect to previously reported methods of preparation, involving the use of the ester form of the terpyridine ligand, trpy(COOCH₃)₃, (see M.K Nazeeruddin et al. Chem. Commun., 1997, 1705), the procedure described in this invention allows to produce molecular sensitizers of the type (TBA)₃[Ru[trpy(COOH) (COO⁻)₂](NCS)₃ with a considerable reduction of the reaction time by a factor of about 300, also in this case the beneficial economic implication can be straightforwardly understood.

Reactions carried out under microwave irradiation of the Ru[trpy(COOH)₃](Cl)₃ species with monodentate ligands ,such as: CN⁻, py, as an example gave complexes of type III with yields of formation in the range 70-80% with reaction times in the range 10-20 minutes. The procedure here described for terpyridine carboxylated ruthenium complexes can also be extended to analogous species containing osmium as well as to phosphonated terpyridine complexes of ruthenium and osmium.

### Method B

a) a pentachlororuthenium complex or ruthenium trichloride hydrate is reacted for 3-6 hours, preferably 4 hours, with an excess of potassium or sodium oxalate in water at 60-100 °C, preferably 80°C.
b) the mixture of step (a) is added with 1.5-2 fold molar excess, preferably, 1.8 fold molar excess of (PO₃R₂)ₙ(CH₂)ₘbpy, where, R represents a methyl or ethyl or, more in general, an alkyl group, to obtain the complex

   Ru[(PO₃R₂)ₙ(CH₂)ₘbpy]₂(C₂O₄).
c) the Ru[(PO₃R₂)ₙ(CH₂)ₘbpy]₂(C₂O₄) complex of step (b) is refluxed for 6-12 hours, preferably for 8 hours in a solvent such as acetonitrile, methanol, tertrahydrofurane or acetone in the presence of a 10-40 fold molar excess of acid, preferably a 20 fold molar excess of hydrochloric acid, in order to hydrolize the phosphonate ester groups and at the same time to get the substitution of the oxalate ligand with two solvent molecules, to form the complex ion [Ru[(PO₃H₂)ₙ(CH₂)ₘbpy ]₂(S)₂]²⁺, where S is the solvent. The solution is then rotary evaporated to dryness and the solvent complex is made to react at reflux for 2-4 hours, preferably 2 hours in solvents such as, methanol, ethanol or water, with an excess of mono-dentate ligand (X) or bi-dentate ligand (Y) to obtain the desired dye.

The process gives high yields in the range 50-80%, allowing for the preparation of high quantities of final compounds in mild reaction conditions.

The synthesis of the intermediate Ru[(PO₃R₂)ₙ(CH₂)ₘbpy]₂(C₂O₄) puts no limit to the production of the wanted dyes; it can in fact be prepared in high quantities with high yield, of the order of 75-80%. Moreover, such intermediate can be prepared in mild conditions.

According to an embodiment of the present invention the commercial product dipotassium pentachlororuthenium hydrate K₂RuCl₅ is reacted in water with an excess (10-30 folds, preferably 20 folds) of sodium- or potassium - oxalate at 60° - 100°C, preferably 80°C.

The (PO₃R₂)ₙ(CH₂)ₘbpy ligand is added and let react for two hours in order to obtain the complex Ru[(PO₃R₂)ₙ(CH₂)ₘbpy]₂(C₂O₄); The complex Ru[(PO₃R₂)ₙ(CH₂)ₘbpy]₂(C₂O₄) is hydrolized in the presence of acid in a solvent S to produce the solvent complex ion [Ru[(PO₃H₂)ₙ(CH₂)ₘbpy ]₂(S)₂]²⁺ . This complex can either be isolated or directly reacted for 3-6 hours, preferably 4 hours, with an appropriated excess of mono-dentate ligand (X) or bi-dentate ligand (Y). The reaction temperature is kept between 60° - 100 °C, preferably 80 °C, and the final product is purified by size exclusion column chromatography and dried.

According to a different embodiment of the invention ruthenium trichloride RuCl₃ hydrate, commercially available, is reacted for 3-6 hours, preferably 4 hours at reflux temperature in aqueous solution with an excess (3-6 folds, preferably 4 folds) of sodium or potassium oxalate in the presence of ethyl alcohol. The ligand (PO₃R₂)ₙ(CH₂)ₘbpy is added, preferably at 50°C, and the mixture is then heated at 60°- 100°C, preferably 80°C for 2 hours.

At this point the complex Ru[(PO₃R₂)ₙ(CH₂)ₘbpy]₂(C₂O₄) is hydrolized in the presence of acid to produce the solvent complex [Ru[(PO₃H₂)ₙ(CH₂)ₘbpy]₂(S)₂]²⁺ which can be isolated or directly reacted with an excess of mono-dentate ligand (X) or bi-dentate ligand (Y) and the reaction carried out as described above.

In repeated preparations, typical yields of formation of the Ru[(PO₃R₂)ₙ(CH₂)ₘbpy]₂(C₂O₄) complex have been observed in the range 75-80%. Conversion of the Ru[(PO₃H₂)ₙ(CH₂)ₘbpy]₂(C₂O₄) species into the solvent complex and subsequent reactions with monodentate or polydentate ligands gave complexes of type IV and V with variable yields of reaction in the range 60-80%.

The products used in the process described are indicated in milligrams (mg) but it is clear that these values are those used in carrying out the processes at a laboratory scale. These amounts are merely intended to disclose the proportions of each product during each step of the process. It is clear that, when carrying out the processes at an industrial scale, in using greater plants, the amounts to be used are increased correspondingly while still keeping the same proportions.

The amounts of the products can consequently be scaled up by a factor ranging between 10 to 100 depending on the size of the reactors used.

The above description and examples disclose several methods and materials of the present invention. This invention is susceptible to modifications in the methods and materials, as well as alterations in the fabrication methods and equipment. Such modifications will become apparent to those skilled in the art from a consideration of this disclosure or practice of the invention disclosed herein. Consequently, it is not intended that this invention be limited to the specific embodiments disclosed herein, but that it covers all modifications and alternatives coming within the true scope and spirit of the invention as embodied in the attached claims.

## Claims

1. Process for the preparation of a Ru(dcbH₂)₂(Cl)₂ complex which is a reaction intermediate compound for the preparation of carboxylate and phosphonate ruthenium polypyridine dyes having the general formula
**Ru(dcbH**_{**2**}**)**_{**2**}**(X)**_{**2**} **(I)**
**Ru(dcbH**_{**2**}**)**_{**2**}**(Y) (II)**
wherein
dcbH₂ is 4,4'-dicarboxy-2,2'-bipyridine or a 5,5'-dicarboxy-2,2'bipyridine,
X is a mono-dentate ligand, such as CN⁻, NCS⁻, py, NC-(CH₂)₂-CN, NC-(CH₂)₃-CN, NC-(CH₂)₄-CN, halide, CO, NO, pyridine, 4-cyanopyridine, dicyanobenzene, H₂O, NH₃ or NO₂⁻,
Y is a bi-dentate ligand of the type: 2,2'-bipyridyl unsubstituted or substituted by one or two -COOH, -B(OH)₂, -PO₃H₂, or -R-PO₃H₂ groups (where R is a saturated or aromatic spacer group, e.g., methylene or phenyl); 1,10-phenanthroline unsubstituted or substituted by one or two-COOH, -B(OH)₂, -PO₃H₂, or -R-PO₃H₂ groups (where R is as defined above); or 2,2'-biquinoline unsubstituted or substituted by one or two -COOH, -B(OH)₂, -PO₃H₂, or -R-PO₃H₂ groups (where R is as defined above), **characterised in that** an amount of 150-500 mg of commercially available ruthenium trichloride and a 250-800 mg of the dcbH₂ ligand is suspended in 30-100 ml of dimethylformamide in a 50-200 ml glass reactor, wherein the mixture is irradiated with microwaves for 8-20 min, by using a power in the range 250-450 W, the solvent is rotary evaporated and the solid stirred in 30-80 ml of HCl 2M for 4 hours in the dark, the solid is filtered and dried in the temperature range 60-90°C under vacuum for giving a yield from 80% to 85% of pure Ru(dcbH₂)₂Cl₂.

2. Process of claim 1 **characterised in that** 250 mg of ruthenium trichloride (RuCl₃) and 420 mg of the dcbH₂ ligand are suspended in 50 ml of dimethylformamide in a 100 ml glass reactor, wherein the mixture is irradiated with microwaves for 12 min by using a power in the range 250-450 W, the solvent is rotary evaporated and the solid stirred in 40 ml of HCl 2M for 4 hours in the dark, the solid is filtered and dried at 80°C under vacuum for giving a yield of 82% of pure Ru(dcbH₂)₂Cl₂.

3. Process of claims 1 and 2 **characterized in that** all the quantities can be scaled up by a factor ranging from 10 to 100.

4. Process for the preparation of Ru(dcbH₂)₂ (NCS)₂ in utilising the Ru(dcbH₂)₂(Cl)₂ complex of claim 1 **characterised in that** a 100-400 mg amount of Ru(dcbH₂)₂Cl₂ and 1.4-5.5 gr of TBANCS (where TBA is the tetrabuthylammonium cation) are suspended in 6-24 ml of a solution containing 5-20 ml of dimethylformamide and 1-4 ml of water in a 25-100 ml glass reactor, wherein the mixture is irradiated with microwaves for 20-50 min, with a power in the range 200-450 W, the solvent is evaporated and the solid dissolved twice at pH 7 in water, the solution is filtered and the Ru(dcbH₂)₂(NCS)₂ complex is precipitated twice at pH 3 by addition of HClO₄, then washed with water and dried for giving a product formation yield of 80% to 85%.

5. Process of claim 4 **characterized in that** 200 mg of Ru(dcbH₂)₂Cl₂ and 2.73 gr of TBANCS (where TBA is the tetrabuthylammonium cation) are suspended in 12 ml of a solution containing 10 ml of dimethylformamide and 2 ml of water in a 50 ml glass reactor, wherein the mixture is irradiated with microwaves for 30 min.

6. Process for the preparation of a Ru[trpy(COOCH₃)₃](Cl)₃ which is a reaction intermediate for the preparation of terpyridines complexes of the general formula
Ru[trpy(COOH)₃](X)₃ (III)
wherein
trpy(COOH)₃ is 4,4',4"-tricarboxy-2,2,6',2"-terpyridine,
X is a mono-dentate ligand of the type: CN⁻, NCS⁻, py, NC-(CH₂)₂-CN, NC-(CH₂)₃-CN, NC-(CH₂)₄-CN, halide, CO, NO, pyridine, 4-cyanopyridine, dicyanobenzene, H₂O, NH₃ or NO₂⁻, **characterized in that** an amount of 50-500 mg of commercially available hydrated ruthenium trichloride and a 70-700 mg amount of the trpy(COOH)₃ ligand are suspended in 7-70 ml of dimethylformamide in a 50-200 ml glass reactor, the mixture is irradiated with a microwaves for 5-15 min by using a power in the range 250- 700 W, the solvent is rotary evaporated and the solid redissolved in a small volume of methanol and reprecipitated with diethylether, giving 440 mg of the trichloro species, corresponding to a yield of 80%.

7. Process of claim 6 **characterized in that** 250 mg of commercially available hydrated ruthenium trichloride and a 350 mg of the trpy(COOH)₃ ligand are suspended in 35 ml of dimethylformamide in a 100 ml glass reactor, the mixture is irradiated with a microwaves for 8 min by using a power in the range 375 W.

8. Process of claims 6 and 7 **characterized in that** all the quantities can be scaled up by a factor ranging from 10 to 100.

9. Process for the preparation of (TBA)₃[Ru[trpy(COOH)(COO⁻)₂](NCS)₃ in utilising the Ru[trpy(COOH)₃](X)₃ complex of claim 6 **characterized in that** a 100- 500 mg amount of Ru[trpy(COOH)₃](Cl)₃ and 1.5-7.9 gr amount of TBANCS (where TBA is the tetrabuthylammonium cation) are suspended in 15-75 ml of dimethylformamide, in a 50-250 ml glass reactor, the mixture is irradiated with microwaves for 5-20 min with a power in the range 200-450 W, the solvent is then evaporated and the solid dissolved at pH 9 in water by the addition of 0.1 M tetrabutylammonium hydroxide solution, the solution is filtered and the (TBA)₃[Ru[trpy(COOH)(COO⁻ )₂](NCS)₃ complex precipitated in the pH range 4.8-5.0 by addition of acid, keeping the solution in an ice bath, the solution is then filtered giving a solid product formation yield of 75-80%.

10. Process of claim 9 **characterized in that** 300 mg of Ru[trpy(COOH)₃](Cl)₃ and 4.7 gr of TBANCS (where TBA is the tetrabuthylammonium cation) are suspended in 45 ml of dimethylformamide, in a 100 ml glass reactor, the mixture is irradiated with microwaves for 10 min with a power in the range 375 W, the solution is filtered and the (TBA)₃[Ru[trpy(COOH)(COO⁻)₂](NCS)₃ complex precipitated in the pH range 4.9 by addition of acid, keeping the solution in an ice bath.

11. Process for the preparation of a carboxylate and phosphonate ruthenium polypyridine dyes in utilising a Ru[(PO₃R₂)ₙ(CH₂)ₘbpy]₂(C₂O₄) complex (R = methyl or ethyl or an alkyl group) as intermediate reaction compound, said dye having the general formula
**Ru[(PO**_{**3**}**H**_{**2**}**)**_{**n**}**(CH**_{**2**}**)**_{**m**}**bpy]**_{**2**}**(X)**_{**2**} **(IV)**
**Ru[(PO**_{**3**}**H**_{**2**}**)**_{**n**}**(CH**_{**2**}**)**_{**m**}**bpy]**_{**2**}**(Y) (V)**
wherein
[(PO₃H₂)ₙ(CH₂)ₘbpy] is a bipyridine ligand which may contain one (one n = 0 and the other n = 1) or two (the two n = 1) phosphonic acid groups in 4,4' or 5,5' position, and such groups can be directly bound to the bipyridine ligand (m = 0) or attached to the bipyridine ligand through a methylene spacer (m = 1),
X is a mono-dentate ligand of the type: CN⁻, NCS⁻, py, NC-(CH₂)₂-CN, NC-(CH₂)₃-CN, NC-(CH₂)₄-CN, halide, CO, NO, pyridine, 4-cyanopyridine, dicyanobenzene, H₂O, NH₃ or NO₂⁻,
Y is a bi-dentate ligand of the type: 2,2'-bipyridyl unsubstituted or substituted by one or two -COOH, -B(OH)₂, -PO₃H₂, or -R-PO₃H₂ groups (where R is a saturated or aromatic spacer group, e.g., methylene or phenyl); 1,10-phenanthroline unsubstituted or substituted by one or two -COOH, -B(OH)₂, -PO₃H₂, or -R-PO₃H₂ groups (where R is as defined above); or 2,2'-biquinoline unsubstituted or substituted by one or two -COOH, -B(OH)₂, -PO₃H₂, or -R-PO₃H₂ groups (where R is as defined above), **characterised in**
a) reacting a pentachlororuthenium complex or ruthenium trichloride hydrate for 3-6 hours with an excess of potassium or sodium oxalate in water at 60-100°C,
b) adding the mixture of step (a) with a 1.5-2 fold molar excess of (PO₃R₂)ₙ(CH₂)ₘbpy, where R represents ethyl or methyl group to obtain the complex Ru[(PO₃H₂)ₙ(CH₂)ₘbpy]₂(C₂O₄),
c) refluxing the Ru[(PO₃H₂)ₙ(CH₂)ₘbpy]₂(C₂O₄) complex of step (b) during 6-12 hours, in a solvent such as acetonitrile, methanol, tetrahydrofurane or acetone in the presence of a 10-40 fold molar excess of acid, of hydrochloric acid, in order to hydrolyse the phosphonate ester groups and at the same time to get the substitution of the oxalate ligand with two solvent molecules, to form the complex ion [Ru[(PO₃H₂)ₙ(CH₂)ₘbpy]₂(S)₂]²⁺ , wherein S represents the solvent; the solution is rotary evaporated to dryness and the solvent complex is made to react at reflux for 2-4 hours, in solvents such as, methanol, ethanol or water, with an excess of mono-dentate ligand (X) or bi-dentate ligand (Y) to obtain the desired dye, for giving a yield from 50% to 80%.

12. Process of claim 11 **characterised in that**
a) a pentachlororuthenium complex or ruthenium trichloride hydrate is reacted for 4 hours with an excess of potassium or sodium oxalate in water at 80°C
b) the mixture of step (a) is added with a 1.8 fold molar excess of (PO₃R₂)ₙ(CH₂)ₘbpy,
c) the Ru[(PO₃H₂)ₙ(CH₂)ₘbpy]₂(C₂O₄) complex of step (b) is refluxed for 8 hours in a solvent such as acetonitrile, methanol, tetrahydrofurane or acetone in the presence of a 20 fold molar excess of hydrochloric acid, the solution is rotary evaporated to dryness and the solvent complex is made to react at reflux for 2 hours in solvents for giving a yield from 75% to 80%.

13. Process of claims 11 and 12 **characterized in that** all the quantities can be scaled up by a factor ranging from 10 to 100.

14. Process of claim 11 **characterized in that**
dipotassium pentachlororuthenium hydrate K₂RuCl₅ is reacted in water with a 10-30 folds excess of sodium- or potassium oxalate at 60°C-100°C;
the (PO₃R₂)ₙ(CH₂)ₘbpy ligand is added and let react for two hours in order to obtain the complex Ru[(PO₃R₂)ₙ(CH₂)ₘbpy]₂(C₂O₄); the complex Ru[(PO₃R₂)ₙ(CH₂)ₘbpy]₂ (C₂O₄) is hydrolized in the presence of acid in a solvent S to produce the solvent complex ion [Ru[(PO₃H₂)ₙ(CH₂)ₘbpy]₂(S)₂]²⁺; this complex can either be isolated or directly reacted for 3-6 hours, with an appropriated excess of mono-dentate ligand (X) or bi-dentate ligand (Y); the reaction temperature is kept between 60°C-100°C and the final product is purified by size exclusion column chromatography and dried.

15. Process of claim 14 **characterized in that**
dipotassium pentachlororuthenium hydrate K₂RuCl₅ is reacted in water with a 20 folds excess of sodium- or potassium oxalate at 80°C;
and the solvent complex ion [Ru[(PO₃H₂)ₙ(CH₂)ₘbpy]₂ (S)₂]²⁺ can either be isolated or directly reacted for 4 hours, the reaction temperature is kept at 80°C.

16. Process of claim 11 **characterized in that**
ruthenium trichloride RuCl₃ hydrate is reacted at reflux temperature in aqueous solution with a 3-6 folds excess of sodium or potassium oxalate in the presence of ethyl alcohol; the ligand [(PO₃R₂)ₙ(CH₂)ₘbpy] is added at 50°C, and the mixture is then heated at 60°C-100°C for 2 hours;
at this point the complex Ru[(PO₃R₂)ₙ(CH₂)ₘbpy]₂(C₂O₄) is hydrolized in the presence of acid to produce the solvent complex [Ru[(PO₃H₂)ₙ(CH₂)ₘbpy]₂(S)₂]²⁺ which can be isolated or directly reacted with an excess of mono-dentate ligand (X) or bi-dentate ligand (Y).

17. Process of claim 16 **characterized in that** the ruthenium trichloride RuCl₃ hydrate is reacted at reflux temperature in aqueous solution with a 4 folds excess of sodium or potassium oxalate in the presence of ethyl alcohol; the mixture is heated at 80°C for 2 hours.

18. Process of claims 1 to 11 **characterized in that** the charge of the complexes is given by the algebraic sum of the oxidation state of the Ru center, in all cases equal to 2+, with the charge of the coordinated X or Y ligands, which can be neutral or negatively charged.

19. Use of the compounds prepared in the process of any claims 1 to 18 for the sensibilisation of wide band-gap semiconductors of type n, (where n stands for negative) for example titanium dioxide, tin dioxide, zinc oxide.

20. Use of the compounds prepared in the process of any claims 1 to 18 for absorbing the dyes on the surface of wide band gap semiconductors or of amorphous silica to produce a photosensitive material which undergoes a color change following irradiation in the Ultraviolet-Visible region, defined by the wavelength range from 200 to 800 nm.

21. Use of the compounds prepared in the process of any claims 1 to 18 as molecular sensitizers in photoelectrochemical regenerating cells based on nanocrystalline electrodes of titanium dioxide.

22. Use of the Ru(dcbH₂)₂(Cl)₂ complex prepared in claim 1 for the preparation of carboxylate and phosphonate ruthenium polypyridine dyes having the general formula I and II.

23. Use of the Ru[(PO₃R₂)ₙ(CH₂)ₘbpy]₂(C₂O₄) complex prepared in claim 11 for the preparation of carboxylate and phosphonate ruthenium polypyridine dyes having the general formula IV and V.

24. Use of the compounds prepared in the process of claims 6 to 10 for the conversion of solar energy into electricity in solar cells based on sensitized nanocrystalline TiO₂.
